# EUROPEAN PATENT APPLICATION

(11) **EP 2 343 568 A1**
(43) Date of publication of application: **13.07.2011**
(21) Application number: 09180995.4
(22) Date of filing: 30.12.2009
(51) Int. Cl.: G01R 33/28, G01R 33/30, G01R 33/62, G01N 24/08, G01N 35/02, G01N 35/04

(54) **Dynamic nuclear polarization apparatus with sample transport system**

(71) Applicant: Koninklijke Philips Electronics N.V., 5621 BA Eindhoven (NL); Philips Intellectual Property & Standards GmbH, 20099 Hamburg (DE)
(72) Inventor: LEUSSLER, Christoph, 5600 AE, Eindhoven (NL); WIRTZ, Daniel, 5600 AE, Eindhoven (NL); BOERNERT, Peter, 5600 AE, Eindhoven (NL); KEUPP, Jochen, 5600 AE, Eindhoven (NL); EGGERS, Holger, 5600 AE, Eindhoven (NL); DAVID, Bernd, 5600 AE, Eindhoven (NL); OVERWEG, Johannes, A., 5600 AE, Eindhoven (NL); ECKART, Rainer, W., 5600 AE, Eindhoven (NL)
(74) Representative: Damen, Daniel Martijn

(57) **Abstract**

The invention relates to a dynamic nuclear polarization apparatus (116) for continuous provision of hyperpolarized samples (114) comprising dynamically nuclear polarized nuclear spins, the apparatus (116) comprising a polarization region (106) for polarization of said nuclear spins resulting in said hyperpolarized samples, wherein the apparatus (116) further comprises:
- a cryostat (102) for cooling the samples (114) in the polarization region (106),
- a magnet (100) for providing a magnetic field to the cooled samples in the polarization region (106),
- a radiation source (112) for concurrently to the magnetic field provision providing a nuclear polarizing radiation to the polarization region (106) for receiving the hyperpolarized samples,
- a sample transport system (104) for continuously receiving unpolarized samples (114), transporting the unpolarized samples to the polarization region (106) for nuclear spin polarization and providing the resulting hyperpolarized samples (114).

## Description

### FIELD OF THE INVENTION

The present invention relates to a dynamic nuclear polarization apparatus, a sample carrier for a dynamic nuclear polarization apparatus, a method of acquiring a magnetic resonance image of an object by magnetic resonance imaging, as well as a computer program product.

Image-forming MR (magnetic resonance) methods which utilize the interaction between magnetic fields and nuclear spins in order to form two-dimensional or three-dimensional images are widely used nowadays, notably in the field of medical diagnostics, because for imaging of soft tissue they are superior to other imaging methods in many respects since they do not require ionizing radiation and are usually not invasive.

According to the MR method in general, the body of the patient to be examined is arranged in a strong, uniform magnetic field whose direction at the same time defines an axis (normally the z-axis) of the coordinate system on which the measurement is based. The magnetic field produces different energy levels for the individual nuclear spins in dependence on the magnetic field strength which can be excited (spin resonance) by application of an electromagnetic alternating field (RF field) of defined frequency (so-called Larmor frequency, or MR frequency). From a macroscopic point of view, the distribution of the individual nuclear spins produces an overall magnetization which can be deflected out of the state of equilibrium by application of an electromagnetic pulse of appropriate frequency (RF pulse) while the magnetic field extends perpendicular to the z-axis (also referred to as longitudinal axis), so that the magnetization performs a precessional motion about the z-axis. The precessional motion describes a surface of a cone whose angle of aperture is referred to as flip angle. The magnitude of the flip angle is dependent on the strength and the duration of the applied electromagnetic pulse. In the case of a so-called 90° pulse, the spins are deflected from the z axis to the transverse plane (flip angle 90°).

After termination of the RF pulse, the magnetization relaxes back to the original state of equilibrium, in which the magnetization in the z direction is built up again with a first time constant T1 (spin lattice or longitudinal relaxation time), and the magnetization in the direction perpendicular to the z direction relaxes with a second time constant T2 (spin-spin or transverse relaxation time). The variation of the magnetization can be detected by means of receiving RF coils which are arranged and oriented within an examination volume of the MR device in such a manner that the variation of the magnetization is measured in the direction perpendicular to the z-axis. The decay of the transverse magnetization is accompanied, after application of, for example, a 90° pulse, by a transition of the nuclear spins (induced by local magnetic field inhomogeneities) from an ordered state with the same phase to a state in which all phase angles are uniformly distributed (dephasing). The dephasing can be compensated by means of a refocusing pulse (for example a 180° pulse). This produces an echo signal (spin echo) in the receiving coils.

In order to realize spatial resolution in the body, linear magnetic field gradients extending along the three main axes are superposed on the uniform magnetic field, leading to a linear spatial dependency of the spin resonance frequency. The signal picked up in the receiving coils then contains components of different frequencies which can be associated with different locations in the body. The signal data obtained via the receiving coils corresponds to the spatial frequency domain and is called k-space data. The k-space data usually includes multiple lines acquired with different phase encoding. Each line is digitized by collecting a number of samples. A set of k-space data is converted to an MR image by means of Fourier transformation.

Conventional magnetic resonance imaging and also nuclear magnetic resonance spectroscopy often lack sensitivity due to low polarizations of nuclear spins comprised in the investigated materials. As a consequence, for example ¹³C and ¹⁵N MRI are not often used due to the low natural occurrence of these isotopes and thus low sensitivity. Hyperpolarization in MRI offers a technology that overcomes the issue of low sensitivity of the desired nuclear spins and permits a real time metabolic profiling and detection of biomarkers using stable isotope precursors and quantitative in vivo imaging.

The degree of polarization of for example ¹³C nuclei can be increased close to unity using a hyperpolarization process like DNP (dynamic nuclear polarization), PHIP (para hydrogen induced polarization), or others. This improves the signal to noise ratio (SNR) in images of these species dramatically.

Especially in imaging hyperpolarized compounds in vivo, time is a very critical factor, since the hyperpolarization typically deceases rapidly once the compound is heated up, transferred from a respective polarizer to the object to be imaged and administered. The process of producing hyperpolarized frozen samples using for example DNP is further time consuming and only small amounts of useable agent are produced per polarization run. Compared to the short T1 time e.g. of hyperpolarized ¹³C agents at room temperature of 60 seconds, the agent has to be irradiated beforehand with microwaves or optically for a long time, typically in the order of several 10 minutes.

### BACKGROUND OF THE INVENTION

US 2009/0051361 A1 does disclose a coolant subassembly for use in a DNP apparatus. In operation, a sample is placed into a respective sample holder cooled down to very low temperatures and afterwards irradiated with microwaves to achieve higher polarization. Afterwards, the sample is melted and pushed out of the device into an NMR working region where an NMR process can be carried out.

However, this permits only to provide one hyperpolarized sample at a time and thus MR measurements applying hyperpolarized samples take a large amount of time.

### SUMMARY OF THE INVENTION

From the foregoing it is readily appreciated that there is a need for an improved dynamic nuclear polarization apparatus. It is consequently an object of the invention to enable MR imaging using hyperpolarized contrast agents in a fast and reliable manner in order to obtain MR data at high quality within a short period of time.

In accordance with the invention, a dynamic nuclear polarization apparatus for continuous provision of hyperpolarized samples comprising dynamically nuclear polarized nuclear spins is disclosed. The apparatus comprises a polarization region for polarization of the nuclear spins resulting in the hyperpolarized samples. The apparatus further comprises a cryostat for cooling the samples in the polarized region, a magnet for providing a magnetic field to the cooled samples in the polarized region, a radiation source for concurrently to the magnetic field provision providing a nuclear polarizing radiation to the polarizing region for receiving the hyperpolarized samples and a sample transport system for continuously receiving unpolarized samples, transporting the unpolarized samples to the polarization region for nuclear spin polarization and providing the resulting hyperpolarized samples, for example to the respective user of the apparatus.

This permits to improve the hyperpolarization process and clinical workflow using batch processing of samples or even continuous provision of polarized samples. The system even permits polarizing different nuclear spins at the same time at different locations in the polarization region. For this purpose the radiation source, for example a microwave or optical assembly providing radiation for polarization might have to be present in multiple versions, each serving one polarizing frequency. Alternatively the assembly is designed such that it can feed multiple samples with the corresponding frequencies.

The microwaves or the optical radiation may be distributed in a suitable way, e.g. using suitable microwave antennas, such that multiple samples are polarized at a time (batch mode). Moreover, the microwave waveguide or in general radiation waveguide may consist of multiple waveguides each providing a different frequency to the sample area. In case of optical radiation, e.g. optical fibers or mirrors might be used to guide the light to the sample.

The improvements allow for improved clinical workflow since batch - or continuously polarized samples - are available eliminating long waiting times between subsequent imaging sessions.

In accordance with an embodiment of the invention, the transport system comprises a conveyer, the conveyer comprising first carrier holders for holding sample carriers adapted for receiving the unpolarized samples and transporting the samples. In this context, the term "conveyer" is understood as any kind of transport line which is able to move sample carriers to and away from the polarizing region. This may be realized for example by a simple conveyer belt. Alternatively or additionally, the conveyer may comprise a gripper for moving the sample from one position to another position and/or to position the samples on the conveyer belt.

In an alternative embodiment, instead of a conveyer belt in case a vertical transport of samples is desired within the polarizing region, a paternoster type of transport system may be used.

In accordance with a further embodiment of the invention, each first carrier holder comprises a passive resonator enhancing the polarizing radiation at its sample location. This overcomes the problem that due to limited incident microwave power especially for polarizing multiple samples at a time, the polarization process may be a long lasting procedure. Locally enhancing the incident field by appropriate passive resonators provides higher field amplitudes at the position of each sample thus easier saturating the hyperfine transition needed for hyperpolarization.

In accordance with an embodiment of the invention, each sample carrier comprises a passive resonator enhancing the polarization radiation at its sample location. In other words, in the embodiment described above the passive resonator is a part of the transport system, whereas according to the present embodiment for each sample an individual sample carrier comprising a passive resonator is provided. As a consequence, each sample has an individual resonator structure which acts as an microwave field enhancer. Here, the coupling of the radiation from the radiation source is realized via inductive or capacitive coupling, for example stripline coupling.

For example, the local resonator may have resonant structures such as spiral, log. periodic, square spiral, or even a dipole array or may comprise an AMC (artificial magnetic conductor) structure. The resonator may comprise a dielectric, the dielectric carrying metallic conductors, the metallic conductors forming the passive resonator. An example for such a carrier may be a carrier similar to a printed circuit board (PCB) carrying etched conductive structures, like for example an array of individual resonators formed by metallic conductors.

As a consequence, a lightweight resonator structure can be provided with low heat capacitance which significantly reduces the loss of helium or any cooling medium during removal or exchange of the sample. Materials like silver or gold with low heat capacitance allow to significantly reduce the coolant (e.g. helium) consumption and thus provide a method for cheap and reliable automatic and continuous sample production. Such kinds of local passive resonators as sample carriers may even be designed as disposables, which may be an important aspect in case the samples held by the sample carriers are hyperpolarized contrast agents which are applied to living organisms and for which it must be ensured that no bacterial contamination is present at the carrier. Disposable carriers overcome this problem of bacterial contamination since there is no need to reuse the carriers again and thus being subject to the risk that bacteria or viruses which contaminated the carrier in a previous use may get in contact with a new sample.

In accordance with a further embodiment of the invention, the apparatus further comprises a sample storage region for storing the hyperpolarized samples, wherein the cryostat is further adapted for cooling the samples in the sample storage region, wherein the magnet is further adapted for providing the magnetic field to the sample storage region and wherein the sample transport system is further adapted for transporting the hyperpolarized samples from the polarization region to the sample storage region for storing the samples in the polarized state and providing individually the resulting hyperpolarized samples on demand.

This has the advantage, that on the one hand, hyperpolarized samples are continuously produced. On the other hand, in case of no continuous requirement of such samples, the samples do not have to be stored with high effort in an external storage system or even be discarded, but the samples will be automatically stored in the sample storage region of the apparatus. In case a hyperpolarized sample is needed, the transport system will provide individually one hyperpolarized sample on demand.

This concept can even be extended by additionally using a monitoring component which monitors the period of time a sample is already present in the sample storage region. In case a predefined time limit is exceeded, the monitoring system will signal the transport system to transport this deteriorated sample back to the polarization region such that the sample can undergo the hyperpolarization process again. The "refreshed" hyperpolarized sample may afterwards be stored again in the sample storage region of the apparatus. Besides using a predefined time limit as the only decision item for repolarizing a sample, the samples may be actively labeled with their actual state of polarization once they leave the polarization region. RFID technology may be used for labeling and reading the data. Having a NMR spectrometer in place in the storage domain the degree of remaining polarization may be checked once in a while in order to decide for or against repolarization.

In accordance with an embodiment of the invention, the sample storage region comprises a conveyer loop, wherein the conveyer loop comprises second carrier holders for holding the sample carriers. In other words, instead of providing a sample storage region with fixed parking places for the hyperpolarized samples, a continuously operating conveyer loop is provided which comprises different second carrier holders for receiving and holding sample carriers comprising hyperpolarized samples. The transport system may comprise again a gripper which positions and thus parks a hyperpolarized sample with its sample carrier automatically onto or into an empty second carrier holder. In case the sample is demanded, the gripper may remove the sample carrier comprising the sample from said holder such that the holder is emptied and again ready for reception of a newly hyperpolarized sample of the polarization region.

In another aspect, the invention relates to a sample carrier for a dynamic nuclear polarization apparatus, the sample carrier being adapted for receiving a sample to be polarized, wherein the sample carrier comprises a passive resonator enhancing at a sample location a polarizing radiation used by the apparatus for polarizing the nuclear spins of the sample.

In accordance with an embodiment of the invention, the resonator comprises a dielectric, the dielectric carrying metallic conductors, the metallic conductors forming the passive resonator.

In accordance with an embodiment of the invention, the passive resonator is formed by an array of individual resonators formed by the metallic conductors, for example by an array of dipoles.

In another aspect, the invention relates to a method of acquiring a magnetic resonance image of an object by magnetic resonance imaging, wherein the method comprises applying a series of sub-boluses of a hyperpolarized contrast agent to the object, acquiring after each sub-bolus application a partial magnetic resonance image of the object and combining the partial images for obtaining a final magnetic resonance image of the object.

In other words, instead of an application of hyperpolarized substances in a single bolus, a fractionated or multiple bolus application is used. In this way, an almost continuous injection or infusion of the agent can be achieved. This flattens the peak concentration of metabolites to be monitored in the region of interest. In this way, the actual for example in vivo observation time window can be lengthened. The replacement of the single bolus by multiple ones does not lead to a loss in temporal resolution, because the signal of the metabolites generated by substrate digestion is fading away due to T1 relaxation. The major gain achievable is an increase in spatial resolution using high spatial resolution imaging (may be spectroscopic imaging), monitoring the products of metabolism.

Additional, by fractionated substrate application, it is also possible to increase the temporal resolution. Assuming that metabolic processes in the object to be imaged are time invariant and reproducible, it is possible to repeat the bolus application changing the delay between the bolus and the MR signal acquisition (boxcar integrator mode). In this way, the temporal resolution can be increased by repeating a couple of these experiments. Consequently, using fractionated or multiple bolus applications permits to perform hyperpolarized MRI or MRS with high temporal and spatial resolutions.

Furthermore, fractionated or repeated bolus injection allows gaining more information. For example, during the individual sub-bolus applications, experimental conditions of the object under study can be changed. In an embodiment of the invention, the object is an organism, such that the method further comprises inducing a change in the metabolic state of the organism after each sub-bolus application. For example it is possible to switch between a rest and a stress mode, the latter for instance introduced by exercise or pharmacological stress (vasodilatation), to study metabolic answers under these changed conditions. This can give valuable information about tissue viability, especially in cardiac applications, tissue response etc.

Other experimental paradigms can be changed, like for instance the global oxygen supply by modifying the breathing atmosphere gaining additional information for example for tumor identification or characterization. The tissue response can be influenced between the individual applications of the hyperpolarized sub-boluses by the use of different agents, enzymes, non-hyperpolarized metabolites entering the digestive chain etc. In this way, the receptive probing of the in vivo system may deliver the information for diagnoses, therapy staging and response of general tissue characterization.

In accordance with a further embodiment of the invention, the method further comprises continuously providing individual doses of the hyperpolarized contrast agent, wherein the method comprises receiving unpolarized contrast agent samples in cryostat of a dynamic nuclear polarization apparatus for cooling the samples in a polarization region of the apparatus. Preferably, the apparatus described above may be used for this purpose. After having received said unpolarized contrast agent samples in the cryostat of the apparatus, a magnetic field is applied to the cooled samples in the polarization region of the apparatus and together with the magnetic field provision a nuclear polarizing radiation is applied to the polarizing region, i.e. to the sample for receiving the hyperpolarized samples. This was already described in detail above.

Further, the method comprises the provision of a sample transport system which is used for continuously receiving the unpolarized samples, transporting the unpolarized samples to the polarization region for nuclear spin polarization and providing the resulting hyperpolarized samples as said individual doses of the hyperpolarized contrast agent.

This allows performing an almost continuous sub-bolus application to the object since the critical time factor of the hyperpolarization decay when heating up the compound for application to the object is circumvented. On demand, as many sub-boluses of hyperpolarized contrast agent are available without a special need for timing between starting of the preparation of samples for hyperpolarization, the application of the sub-boluses to the object and performing of the magnetic resonance imaging process. Having a batch process in place for polarizing several samples in series or even several samples in parallel at a time allows for multiple shots, which in turns enables a whole range of new sample application, for example injection paradigms. This concept can even be extended to continuous polarization and administration. There may also be a need for imaging multiple nuclei at a time in order to get even more insight in metabolism and cell function. For this purpose, the polarizer can be prepared for handling several species like ¹³C and ¹⁵N at the same time.

Up to now, the samples which were polarized for example using DNP formed frozen droplets immersed in liquid helium at temperatures around 1K until they were rapidly melted in a zone of 4.2K and administered in liquid phase. For saving helium and costs, a closed cycle cooler could be applied for both the polarization itself as well as for operating the intermediate storage mentioned above as "sample storage region". In this case, the closed cycle cooler recondensates the pumped helium and thus enables zero or at least drastically reduced helium boil-off.

In a further embodiment of the invention, the method further comprises determining a bolus concentration of the contrast agent required for acquiring a desired magnetic resonance image of an object with a desired spatial and spectral resolution when applying the bolus at once. Further, a concentration of individual sub-boluses is selected, wherein said concentration of the individual sub-boluses is below said determined bolus concentration.

As already discussed above, this flattens the peak concentration of metabolites to be monitored in the region of interest, wherein in this way the actual observation time window can be lengthened.

The method of the invention can be advantageously carried out in most MR devices in clinical use at present. To this end, it is merely necessary to utilize a computer program by which the MR device and also preferably the above mentioned dynamic nuclear polarization apparatus is controlled such that it performs the above explained method steps of the invention. The computer program may be present either on a data carrier or be present in a data network so as to be downloaded for installation in the control unit of the MR device and/or the dynamic nuclear polarization apparatus. Therefore, the invention also relates to a computer program product comprising computer executable instructions to perform the method as described above.

### BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:
Fig. 1 shows a dynamic nuclear polarization apparatus for continuous provision of hyperpolarized samples;
Fig. 2 illustrates a DNP apparatus further comprising a gripping mechanism to move samples;
Fig. 3 illustrates a vertical DNP apparatus comprising a paternoster type system;
Fig. 4 illustrates an individual resonator of a sample with electromagnetic coupling to a feed;
Fig. 5 illustrates groups of individual samples which are fed by separate microwave generators;
Fig. 6 illustrates different surface structure for a resonator structure;
Fig. 7 shows the difference between the application of a conventional and fractional boluses;
Fig. 8 illustrates a method of bolus application with changing the delay between the bolus and the MR signal acquisition for a series of sub-bolus applications;
Fig. 9 illustrates the change of the object state in between repetitive boluses;
Fig. 10 illustrates the interaction between a polarizer, an MR system and a computer unit controlling the provision of hyperpolarized samples to the object to be imaged at the MR data acquisition process.

### DETAILED DESCRIPTION OF EMBODIMENTS

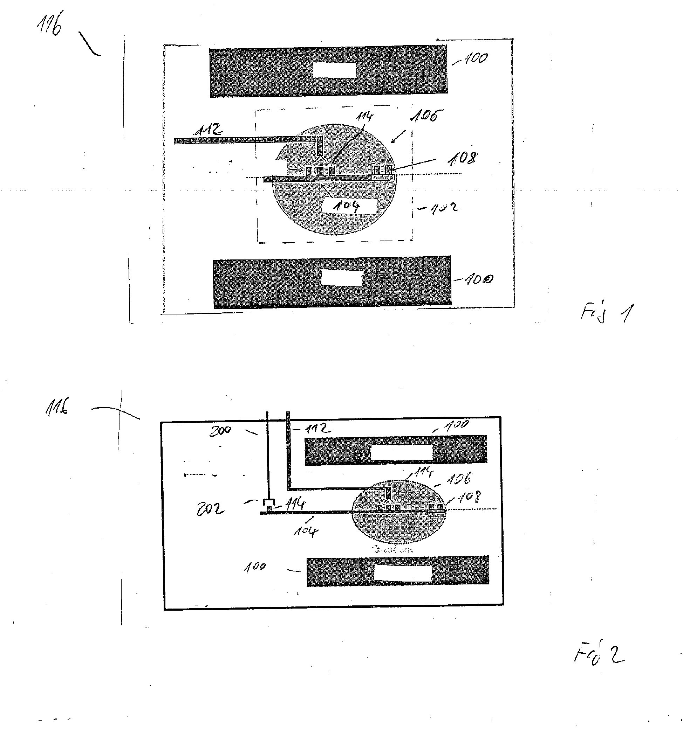

Figure 1 shows a dynamic nuclear polarization apparatus 116 for continuous provision of hyperpolarized samples 114. The apparatus comprises a polarization region 106 for polarization of the nuclear spins of the samples to be hyperpolarized. For hyperpolarization purposes, the system comprises a cryostat 102 for cooling the samples 114 in the polarization region 106. Further a radiation source 112 is provided for providing a nuclear polarization radiation to the polarization region 106 for receiving the hyperpolarized samples. Inside the sufficiently homogeneous region 106 of the polarizer magnet a conveyer belt 104 is operated. It supplies samples to the region of microwave or optical irradiation and moves them to a dedicated storage area 108. The resonators are not shown and can be thought as of being integrated in the sample holders or surrounding them.

The conveyer belt and the sample transport may be manually controlled or operated using a computer and a respective computer program product. The belt may be moved using an electrical or a mechanical drive.

The homogeneous magnetic field is generated by magnets 100, wherein the magnetic field is homogeneously provided to the polarization region 106, as well as to the sample storage region 108.

In the embodiment shown in Figure 1, the polarization region extends over the sample storage region. In other words, the same magnetic field provided to the samples when irradiating the samples for receiving the hyperpolarized samples is used for storing of the samples in the hyperpolarized state in the sample storage region. A part of the polarization region is thereby used for provision of the nuclear polarizing radiation, wherein the homogeneous magnetic field extends over this area to the sample storage region.

Figure 2 shows the realization of how samples 114 are brought into and taken out of the magnet system 100. Again a conveyer belt 104 is used for transporting the samples to a defined location where a gripping mechanism 200 comprising a gripper 202 is in place allowing for placing and removing samples 114. This mechanism 200 may be equipped with the possibility of injecting hot liquid for dissolving the sample while remaining in the high magnetic field, i.e. within the cryostat but not immersed in the liquid helium.

For continuous hyperpolarization, the polarizer magnet may be located in a cryostat that allows access from two sides. Samples are for example automatically introduced through a first port. This may either be performed serially or in a batch mode, i.e. a batch of several samples may be introduced at a time. The samples may then be manually or automatically placed onto the conveyer belt inside the cryostat and moved through the region of irradiation at a speed ensuring proper polarization. The polarized samples leave the magnet or are dissolved within the magnet through the second port. Thus, a continuous or quasi continuous hyperpolarization is realized.

In this context it has to be clarified that "continuous provision" may also comprise a quasi continuous provision of hyperpolarized samples. For example, for hyperpolarization purposes the samples may remain in the area at which the polarizing radiation is applied to the samples for a predefined period of time. Unpolarized samples are supplied continuously at a given cycle time to the first port and polarized samples are continuously received at the same cycle time at the second port. However, in case no samples are actually required, the transport system comprising the conveyer belt may be adapted to automatically move the hyperpolarized samples to the sample storage region 108 for temporally storing the samples and providing them on the second port on demand.

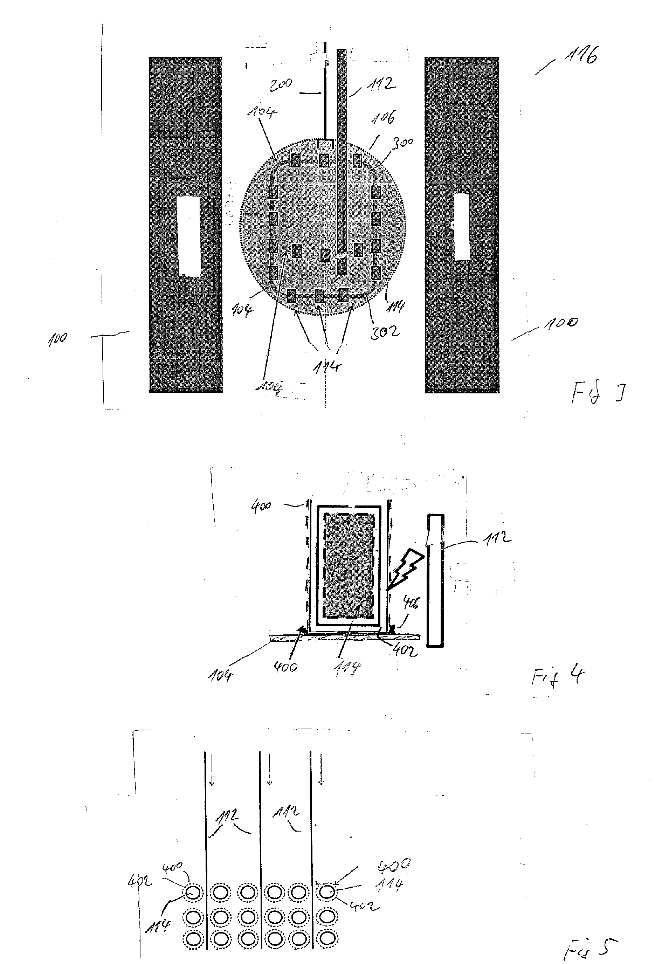

Figure 3 shows an embodiment employing a paternoster type of transport system. While a number of samples 114 circle with the system in a loop 302 and are polarized employing one or several polarization regions, a dedicated storage loop 300 is available for storing partly or fully polarized samples 114 for delayed usage. Again, a suitable pick and place mechanism 200 may be used to load the cryostat and remove samples. The pick and place mechanism 200 may also be equipped for injecting a liquid and thawing the samples, if required.

From the above description it becomes clear, that the cryostat preferably extends over both, the polarization region, as well as the sample storage region. Preferably, a single closed cryostat system is used for this purpose such that the cooling space of the cryostat extends over the polarization region and the sample storage region.

Figure 4 illustrates a sample 114 which is carried in a sample carrier 402. In order to fix and attach the sample carrier 402 to the conveyer belt 104, the conveyer belt 104 may comprise a carrier holder 406.

It has to be noted that instead of a conveyer belt 104 any other type of conveyer may be used which is suitable for transporting a sample within a DNP apparatus. This may be for example, but not limited to a system of robotic arms comprising mechanical grippers, or just may be a cable based system in which the individual carrier holders are interconnected by cables connected to a drive system pulling the cables and thus moving the carrier holders.

In order to provide efficiently radiation like microwaves or optical radiation to the samples, preferably the samples 114 are located in a resonator, which acts as an microwave field (i.e. radiation) enhancer. For this purpose, respective resonators may be either a part of the carrier holders or a part of the sample carriers. In the embodiment shown in Figure 4, the resonator is comprised on the sample carrier 402 as a resonator structure 400. As a consequence, each sample has its own passive resonator. The local resonators of the individual samples couple with the incoming irradiating microwave field of the antenna 112. The microwave field may be fed to the resonator via inductive or capacitive coupling. This is shown in detail in Figure 5.

In Figure 5 groups of individual samples 114 which are received in sample carriers are fed by separate microwave generators. The microwaves (or in general radiation) is fed to the local resonators by striplines or waveguides 112. A stripline is a transverse electromagnetic transmission line medium. Since each sample comprises its own passive resonator, the electromagnetic field present at each individual sample is the field provided by each resonator respectively.

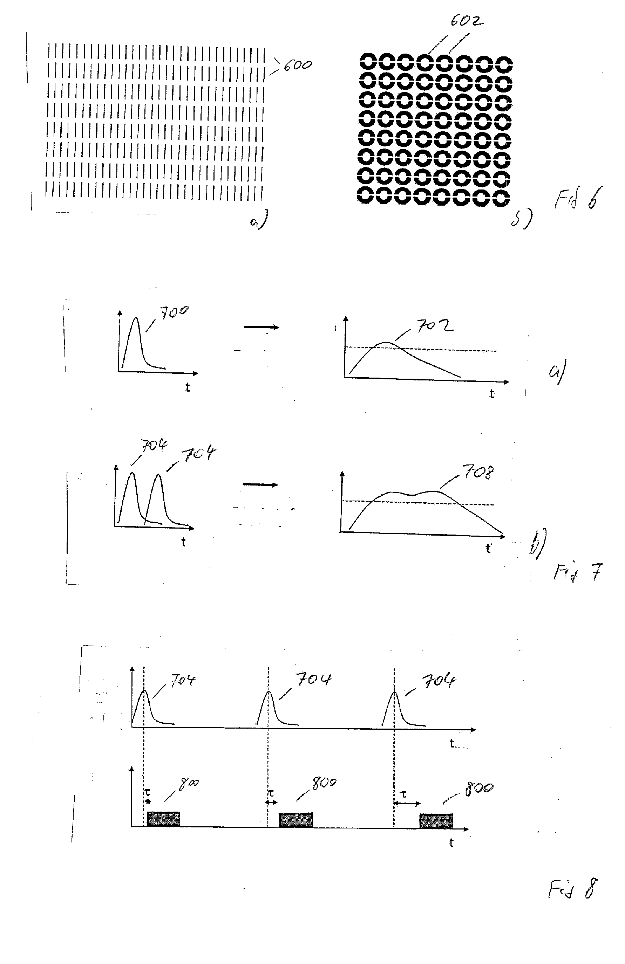

As resonating structure 400, various possibilities exist for practical realization. As illustrated in Figure 6a, a dipole array may be used which has the advantage of easy manufacturability for example by printed circuit board manufacturing techniques. In case the material of the sample carrier is a printed circuit board material, the dipole array 600 may be produced on the outer or inner surface of the sample carrier by standard etching techniques. As a consequence, such a structure may be produced in a cheap and fast manner, such that it is possible to provide disposable sample carriers.

Instead of providing a dipole array by means of individual dipoles realized as short conducting lines, it is also possible to provide a structure inverse to the structure shown in Figure 6a. I.e. a metalized surface may be provided, wherein the surface comprises recesses. This also results in an array of dipoles.

Instead of using a printed circuit board material for the sample carrier, any kind of material may be used with low heat capacitance and which is a low loss dielectric.

As conductor material for creating the conducting structure on the low loss dielectric, highly conductive metals with low heat capacitance should be used. Examples are for example silver or gold. Since only extremely small amounts of metallic material are required for providing the resonating structure on the sample carrier, the total heat capacitance of the sample carrier is minimized and thus a respective coolant consumption when moving the sample to the cryostat is minimized. Furthermore, since the resonator acts as a field enhancer, incident microwave power may also be reduced.

Figure 6b shows a further resonator structure, wherein this structure comprises half loops 602. However, it has to be noted that any kind of resonating structure which is coupling to the incident electromagnetic field for enhancing the electromagnetic field locally may be used, such as but not limited to a spiral, log. periodic, square spiral or any other kind of array.

As already discussed in detail above, the components mentioned above, i.e. the sample carrier and the DNP apparatus provide the possibility to realize a continuous or quasi continuous provision of hyperpolarized samples, like for example contrast agents such that a respective clinical workflow can significantly be improved by continuously or quasi continuously supplying "freshly" hyperpolarized agents for administration.

One example of such a clinical work flow improvement shall be discussed with respect to Figure 7. In Figure 7a, a state of the art bolus application of a hyperpolarized sample, for example a hyperpolarized contrast agent, is shown. The initial bolus 700 is convolved with the hemodynamic response function (right) 702 if the hyperpolarized agent is applied for example to the blood stream of an organism. In contrast, as shown in Figure 7b due to the fractional bolus application 704, i.e. the application of a series of sub-boluses 704 of the hyperpolarized contrast agent, the hemodynamic response function 708 at the region of interest is increased.

An example for the suitability of applying a series of sub-boluses of a hyperpolarized contrast agent to an organism is the following: A whole body or very large field of view application should be performed to perform whole body tumor detection and/or characterization. However, in case the desired field of view (FOV) is larger than the homogeneity volume of the scanner, performing of multi-station hyperpolarized MR imaging is necessary. For this purpose, MR data acquisition in multi-station magnetic resonance imaging is performed in different scan segments, while the table at rest for a given scan segment. Once data acquisition is performed for one section the table may be moved to the next section scanning a different portion of the body. By means of the method mentioned above, fractionated hyperpolarized sub-boluses of the contrast agent may be continuously or quasi continuously applied to the region of interest such that it is possible to finally receive by combination of the partial images of the individual sections a final magnetic resonance image of the object with unprecedented high quality.

A further example for applying a series of sub-boluses of a hyperpolarized contrast agent is shown in Figure 8: In Figure 8, small changes of tissue metabolism or reaction to external triggers is investigated. As external stimulus a repetitive change between an oxygen enriched and non oxygen enriched atmosphere may be chosen. This may be performed in switching between the on/off-mode repetitively, roughly 10-100 times. Synchronized to this paradigm, hyperpolarized MR is performed which may be cardiac gated, preceded by the application of a small but definite bolus, i.e. sub-bolus 704, allowing the corresponding MR experiments. In the couple of repetitive experiments, the timing of the MR data acquisition 800 is delayed with respect to the time of the bolus. This enables to reach a high temporal resolution, also called a boxcar integrator modus. After the experiment an additional statistical data analysis step is performed on the reconstructed time series. The analysis consists basically in a correlation of the stimuli paradigm at the MR data, either voxel-wise and/or spectra-wise. This measurement approach allows the identification of very tiny signal changes.

It has to be noted that for the discussed approach it is also possible to keep the timing of the MR data acquisition 800 fixed with respect to the timing of the sub-bolus application.

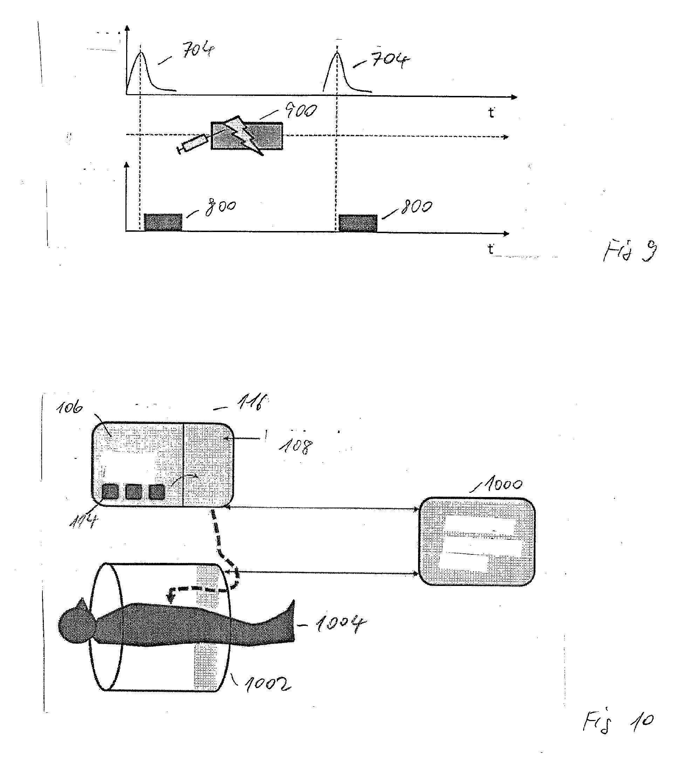

A further example how to profit from the continuous or quasi continuous provision or the provision on demand of hyperpolarized samples is illustrated in Figure 9. To characterize a certain tumor in more detail, MRI may be used to monitor the digestion of ¹³C hyperpolarized pyruvate. For this purpose, fast ¹³C spectroscopic imaging is used. To gain more information, fractional bolus injection 704 may be applied while the condition of the object under study is changed, as indicated by reference numeral 900. After a first bolus of pyruvate and corresponding imaging, a special agent or enzyme is administrated to the body, either in a systemic way of very locally by an appropriate injection or a catheter. This enzyme or agent is known to block specific metabolic pathways in very specific tumor cells. After a time sufficient for the first bolus to reach the cells, but short enough to avoid potential enzyme wash-out, a second bolus 704 of pyruvate is administered, followed by corresponding ¹³C imaging 800. Based on analysis of the respective MR images acquired by the data acquisition 800 after each bolus provision, it is possible to precisely identify the tumor on its stage.

As further illustrated in Figure 10, the entire sample production process by means of the DNP apparatus 116, the amount of hyperpolarized material and a respective administration time to an object 1004 (for example a patient), including gating and triggering to physiology, may be supervised by a corresponding computer 1000 which runs a respective computer program. Said computer 1000 may control the MRI system 1002, as well as the DNP apparatus 100. As already discussed above, the DNP apparatus may preferably comprise the transport system, as well as a sample storage region 108 for storing hyperpolarized samples and providing the samples on demand.

## Claims

1. A dynamic nuclear polarization apparatus (116) for continuous or batch wise provision of hyperpolarized samples (114) comprising dynamically nuclear polarized nuclear spins, the apparatus (116) comprising a polarization region (106) for polarization of said nuclear spins resulting in said hyperpolarized samples, wherein the apparatus (116) further comprises:
- a cryostat (102) for cooling the samples (114) in the polarization region (106),
- a magnet (100) for providing a magnetic field to the cooled samples in the polarization region (106),
- a radiation source (112) for concurrently to the magnetic field provision providing a nuclear polarizing radiation to the polarization region (106) for receiving the hyperpolarized samples,
- a sample transport system (104) for continuously receiving unpolarized samples (114), transporting the unpolarized samples to the polarization region (106) for nuclear spin polarization and providing the resulting hyperpolarized samples (114).

2. The apparatus (116) of claim 1, wherein the transport system comprises a conveyer (104), the conveyer comprising first carrier holders (406) for holding sample carriers (402) adapted for receiving the samples (114) and transporting the samples.

3. The apparatus (116) of claim 2, wherein each first carrier holder (406) comprises a passive resonator enhancing the polarizing radiation at its sample location.

4. The apparatus (116) of claim 2, wherein each sample carrier (402) comprises a passive resonator (400) enhancing the polarizing radiation at its sample location.

5. The apparatus (116) of claim 1, further comprising a sample storage region (108) for storing the hyperpolarized samples, wherein the cryostat (102) is further adapted for cooling the samples in the sample storage region (108), wherein the magnet (100) is further adapted for providing the magnetic field to the sample storage region (108) and wherein the sample transport system (104) is further adapted for transporting the hyperpolarized samples from the polarization region (106) to the sample storage region (108) for storing the samples in the polarized state and providing individually the resulting hyperpolarized samples on demand.

6. The apparatus (116) of claim 5, wherein the sample storage region (108) comprises a conveyer loop (300), the conveyer loop comprising second carrier holders for holding the sample carriers.

7. A sample carrier (402) for a dynamic nuclear polarization apparatus (116), the sample carrier being adapted for receiving a sample (114) to be polarized, wherein the sample carrier comprises a passive resonator (400) enhancing at the sample location a polarizing radiation used by the apparatus (116) for polarizing the nuclear spins of the sample.

8. The carrier of claim 7, wherein the resonator (400) comprises a dielectric, the dielectric carrying metallic conductors, the metallic conductors forming the passive resonator.

9. The carrier of claim 8, wherein the passive resonator (400) is formed by an array (600, 602) of individual resonators formed by the metallic conductors.

10. A method of acquiring a magnetic resonance image of an object (1004) by magnetic resonance imaging, the method comprising:
- applying a series of sub-boluses of a hyperpolarized contrast agent to the object,
- acquiring after each sub-bolus application a partial magnetic resonance image of the object,
- combining the partial images for obtaining a final magnetic resonance image of the object.

11. The method of claim 10, further comprising:
- determining a bolus concentration of the contrast agent required for acquiring a desired magnetic resonance image of an object with a desired spatial and spectral resolution when applying the bolus at once,
- selecting a concentration of the individual sub-boluses, wherein said concentration of the individual sub-boluses is below said determined bolus concentration.

12. The method of claim 10, further comprising continuously providing individual doses of the hyperpolarized contrast agent the method comprising:
- receiving unpolarized contrast agent samples (114) in a cryostat (102) of a dynamic nuclear polarization apparatus (116) for cooling the samples in a polarization region (106) of the apparatus (116),
- providing a magnetic field to the cooled samples in the polarization region (106),
- providing concurrently to the magnetic field provision a nuclear polarizing radiation to the polarizing region for receiving the hyperpolarized samples (114),
wherein a sample transport system (104) is used for continuously receiving the unpolarized samples, transporting the unpolarized samples to the polarization region (106) for nuclear spin polarization and providing the resulting hyperpolarized samples as said individual doses of the hyperpolarized contrast agent.

13. The method of claim 10, wherein the object (1004) is an organism, wherein the method further comprises inducing a change in the metabolic state of the organism after each sub-bolus application.

14. A computer program product comprising computer executable instructions to perform the method steps as claimed in any of the previous claims 10 to 13.
